# EUROPEAN PATENT SPECIFICATION

(11) **EP 1 858 983 B1**
(45) Date of publication and mention of the grant of the patent: **17.09.2008**
(21) Application number: 06729606.1
(22) Date of filing: 15.03.2006
(51) Int. Cl.: C08L 83/06, C08L 63/00, H01L 23/29

(54) **CURABLE SILICONE COMPOSITION AND ELECTRONIC DEVICE PRODUCED THEREFROM**
HÄRTBARE SILIKONZUSAMMENSETZUNG UND DARAUS HERGESTELLTE ELEKTRONISCHE VORRICHTUNG
COMPOSITION DE SILICONE DURCISSABLE ET DISPOSITIF ELECTRONIQUE PRODUIT A PARTIR DE CELLE-CI

(30) Priority: 15.03.2005 JP 2005072395
(43) Date of publication of application: 28.11.2007
(73) Proprietor: Dow Corning Toray Co., Ltd., Tokyo 100-0005 (JP)
(72) Inventor: MORITA, Yoshitsugu C/o Dow Corning Toray Co.Ltd., Chiba, 2990108 (JP); ISSHIKI, Minoru, Ehime 7913120 (JP); UEKI, Hiroshi C/o Dow Corning Toray Co., Ltd., Chiba, 2990108 (JP); KATO, Tomoko C/o Dow Corning Toray Co., Ltd., Ichihara-shi, Chiba, 2990108 (JP)
(74) Representative: Gillard, Richard Edward
(86) International application number: PCT/JP2006/305639
(87) International publication number: WO 2006/098493

(56) References cited:
- EP-A- 0 464 706
- EP-A- 0 543 384
- EP-A- 0 571 965
- EP-A- 0 620 242
- EP-A- 0 821 038

## Description

### Technical Field

The present invention relates to a curable silicone composition and electronic devices produced with the use of the composition. More specifically, the invention relates to a curable silicone composition that is characterized by perfect handlability and curability, and that, when cured, forms a cured body that possesses flexibility and adhesive properties. The invention also relates to electronic devices that are reliable and sealed or adhesively attached with the use of the aforementioned composition.

### Background Art

The problem associated with known curable resin compositions, such as, e.g., epoxy resin compositions used as sealants and adhesives for parts of electrical and electronic devices, is high stress that can easily develop in the aforementioned parts because of high modulus of elasticity and rigidity when these parts are subject to thermal expansion. Furthermore, cracks can easily develop in the cured resin itself when the parts or substrates of the electronic or electrical devices are subject to buckling, or gaps may occur between the parts and the cured bodies of resin. In some cases, the parts may become damaged.

In order to reduce development of stress in the cured products, it has been proposed to use the following substances: a curable resin composition that contains a silicone resin with epoxy groups (see Japanese Unexamined Patent Application Publication (hereinafter referred to as "Kokai") H5-295084); a die-attaching paste prepared from a product of a reaction of an epoxy resin and a cyanate resin with an epoxy-containing dimethylsiloxane compound (see Kokai H10-147764 and Kokai H10-163232); or a die bonding material comprised of a product of a reaction between an epoxy-containing silicone oil and a phenolic-type organic compound (see Kokai H7-22441, Kokai H7-118365, and Kokai H10-130465). However, the cured bodies produced from these substances possess rigidity and their stress-reduction efficiency is still low. Therefore their use for parts of electrical and electronic devices is limited.

On the other hand, since curable silicone compositions possess excellent electrical characteristics such as dielectric properties, coefficient of volumetric resistance and resistance of insulation to voltage breakdown, these compositions are used as sealants and adhesives for parts of electrical and electronic devices. However, since the cured bodies obtained from such compositions are soft and have low strength and low modulus of elasticity, their mechanical protective properties for electrical and electronic devices, i.e., protection against external impacts that may be applied to such devices, are very low. Another drawback is a low adhesive strength of the cured products of the composition to electrical and electronic devices, whereby gaps may occur between the parts and the cured products. Attempts have been made to reduce the coefficient of thermal expansion of the soft cured bodies by filling their materials with fillers. In this case, however, the products lose their softness and flexibility.

Kokai H6-306084 discloses a curable silicone composition that has a short gel-formation time and is composed of an epoxy-modified silicone oil and phenol-modified silicone oil. However, this curable silicone composition has poor curability and requires long heating for curing. Another problem is that cured products prepared from this composition are extremely brittle.

It is an object of the present invention to provide a curable silicone composition that possesses excellent handlability and curability, and that, when cured, forms a cured product of good flexibility and with excellent adhesive properties. It is another object to provide highly reliable electronic devices.

### Disclosure of Invention

The curable silicone composition of the present invention comprises:
(A) a diorganosiloxane represented by the following general formula:

   A-R²-(R¹₂SiO)ₙR¹₂Si-R²-A

   {wherein R¹ represents the same or different optionally substituted univalent hydrocarbon groups that do not have unsaturated aliphatic bonds; R² represents bivalent organic groups; A represents siloxane residual radicals represented by the following average unit formula:

   (XR¹₂SiO_{1/2})ₐ(SiO_{4/2})_{b}

   (wherein R¹ designates the previously mentioned groups; X designates a single bond, hydrogen atom, the previously mentioned group that is designated by R¹, an epoxy-containing alkyl group, or an alkoxysilylalkyl group; with the proviso that at least one X in one molecule is a single bond; at least two X's are epoxy-containing alkyl groups; "a" is a positive number, "b" is a positive number; and "a/b" is a positive number within the range of 0.2 to 4), and "n" is an integer which is equal to or greater than 1}; and
(B) a curing agent for an epoxy resin.

An electronic device of the present invention is sealed or adhered with the use of a cured body produced from the aforementioned curable silicone composition.

### Effects of Invention

Since the curable silicone composition of the invention is characterized by excellent handlability and curability, it can be molded during a short time and at low heating temperatures. This, in turn, makes it possible to reduce inner stress caused by thermal expansion and to prevent damage when the composition is used as a protective agent, sealant, or an adhesive agent for delicate and brittle parts. Furthermore, the composition provides strong adhesion to various substrates. Since the electronic devices of the invention are sealed or adhesively attached with the use of a cured body of the above-described composition, they acquire high reliability.

### Brief Description of the Drawings

Fig. 1 is a sectional view of an LSI as an example of an electronic device of the invention.

fig. 2 is a sectional view of another LSI as an example of an electronic device of the invention.

### Reference numbers

- 1: semiconductor element
- 2: substrate
- 3: ball grid
- 4: heat spreader
- 5: heat radiating element
- 6: heat radiating fin
- 7: heat radiating element
- 8: external lead
- 9: internal lead
- 10: bonding wire
- 11: sealant

### Detailed Description of the Invention

A detailed description will be given first to the curable silicone composition of the invention.

The diorganosiloxane of component (A) is a main component of the composition of the invention. It is represented by the following general formula:

A-R²-(R¹₂SiO)ₙR¹₂Si-R²-A

In this formula, R¹ may be the same or different and designates optionally substituted univalent hydrocarbon groups that do not have aliphatically unsaturated bonds. The following are specific examples of such univalent hydrocarbon groups: methyl, ethyl, propyl, butyl, pentyl, hexyl, or similar alkyl groups; cyclopentyl, cyclohexyl, cycloheptyl, or similar cycloalkyl groups; phenyl, tolyl, xylyl, or similar aryl groups; benzyl, phenethyl, phenylpropyl, or similar aralkyl groups; 3-chloropropyl, 3,3,3-trifluoropropyl, or similar halogenated alkyl groups. Most preferable are alkyl groups, especially methyl groups. In the above formula, R² designates a bivalent organic group, such as ethylene, methylethylene, propylene, butylene, pentylene, hexylene, or a similar alkylene group; ethyleneoxy ethylene, ethyleneoxy propylene, ethyleneoxy butylene, propyleneoxy propylene, or a similar alkylenoxy alkylene group. Most preferable of these groups is the alkylene group, especially the ethylene group. Furthermore, in the above formula, "n" is an integer equal to or greater than 1 and designates a degree of polymerization of the diorganosiloxane in the main molecular chain. From the view point of better flexibility in a cured body of the aforementioned composition, it is recommended that "n" is an integer not less than 10. Although there are no special restrictions with the regard to the upper limit of "n", it is recommended that "n" is an integer not more than 500.

In the above formula, "A" designates siloxane residual radicals represented by the following average unit formula:

(XR¹₂SiO_{1/2})ₐ(SiO_{4/2})_{b},

wherein R¹ may be the same or different and designates optionally substituted univalent hydrocarbon groups that do not have aliphatically unsaturated bonds. These groups are the same as exemplified above, and preferably be alkyl groups, especially methyl groups. Furthermore, in the above formula X designates a single bond, hydrogen atom, the previously mentioned group that is designated by R¹, an epoxy-containing alkyl group, or an alkoxysilylalkyl group. Examples of groups designated by R¹ are the same as those given above. The following are examples of epoxy-containing alkyl groups: 2-glycidoxyethyl, 3-glycidoxypropyl, 4-glycidoxybutyl, or a similar glycidoxyalkyl group; 2-(3,4-epoxycyclohexyl) ethyl, 3-(3,4-epoxycyclohexyl) propyl, or a similar 3,4-epoxycyclohexylalkyl group; 4-oxylanylbutyl, 8-oxylanyloctyl, or a similar oxylanylalkyl group. The alkoxysilylalkyl group can be represented by a trimethoxysilylethyl group, trimethoxysilylpropyl group, dimethoxymethylsilylpropyl group, methoxydimethyl-silylpropyl group, triethoxysilylethyl group, and a tripropoxysilylpropyl group. At least one X in one molecule is a single bond. This bond is used for bonding to R² in the formula of the aforementioned diorganopolysiloxane. Furthermore, at least two X's are epoxy-containing alkyl groups, preferably glycidoxyalkyl groups, and even more preferably, 3-glycidoxypropyl groups. In the formula, "a" is a positive number, "b" is a positive number; and "a/b" is a positive number within the range of 0.2 to 4.

There are special limitations with regard to the molecular weight of component (A), but it can be recommended that the weight-average molecular weight be within the range of 500 to 1,000,000. Also, there are no special restrictions with regard to the state of component (A) at 25°C, but it is preferable that it is a liquid with viscosity in the range of 50 to 1,000,000 mPa·s. The diorganosiloxane suitable for use as component (A) can be prepared by a method described, e.g., in Kokai H6-56999.

The epoxy resin curing agent of component (B) cures the composition by reacting with the epoxy groups of component (A). It is recommended that this curing agent be a compound that contains in one molecule at least two functional groups reactive with the epoxy groups. The aforementioned functional groups may be exemplified by primary amine groups, secondary amine groups, hydroxyl groups, phenolic hydroxyl groups, carboxylic acid groups, acid anhydride groups, mercapto groups, and silanol groups. From the point of view of better reactivity and pot life, phenolic hydroxyl groups are preferable. In other words, it is preferable that component (B) is a phenolic compound such as a phenolnovolac resin, cresol novolac resin, bisphenol A type compound, or a similar phenolic resin, or an organosiloxane that contains phenolic hydroxyl groups. For better reactivity, the phenolic hydroxyl group equivalent should not exceed 1,000, and preferably should not exceed 500.

In order to provide improved flexibility in a cured body of the composition of the invention, it is recommended that the organosiloxane contained in component (B) be comprised of a diorganosiloxane of the following general formula:

B-(R¹₂SiO)ₘR¹₂Si-B

(wherein R¹ may be the same or different and designates an optionally substituted univalent hydrocarbon group that does not have aliphatically unsaturated bonds; B is an organic group that contains a phenolic hydroxyl group, and "m" is an integer that is equal to or greater than 1. R¹ that may be the same or different and designates optionally substituted univalent hydrocarbon groups without aliphatically unsaturated bonds can be exemplified by the same groups as given above and preferably be alkyl or aryl groups, especially methyl and phenyl groups. Organic group B that contains a phenolic hydroxyl group can be represented by specific examples given below. In the above formula, R³ is a bivalent organic group that can be exemplified by ethylene, methylethylene, propylene, butylenes, pentylene, hexylene, or a similar alkylene group; ethyleneoxyethylene, ethyleneoxypropylene, ethyleneoxybutylene , propyleneoxypropylene, or a similar alkyleneoxyalkylene group. Most preferable is the alkylene group, especially the propylene group.

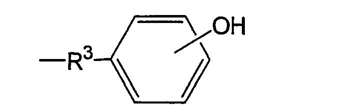

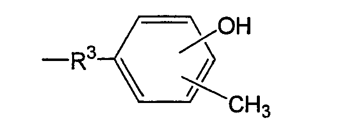

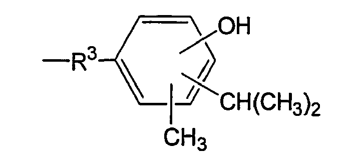

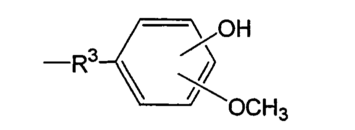

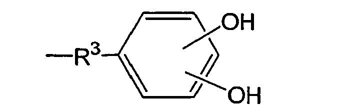

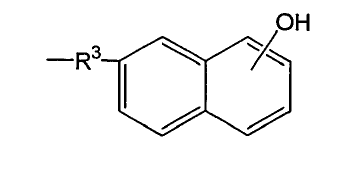

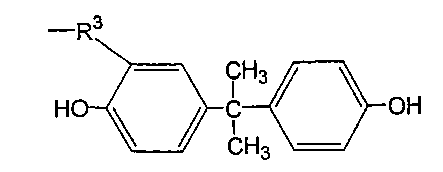

In the above formula, "m" is an integer that is equal to or greater than 1, preferably an integer within the range of 1 to 1,000, more preferably within the range of 1 to 100, and even more preferably within the range of 1 to 20. If the value of "m" exceeds the recommended upper limit, it will be difficult to handle component (B) and to mix it with component (A). It will also be impossible to use the composition if it is diluted with a solvent.

The organosiloxane that constitutes component (B) can be represented by the following examples, wherein "x" is an integer within the range of 1 to 20, and "y" is an integer within the range of 2 to 10.

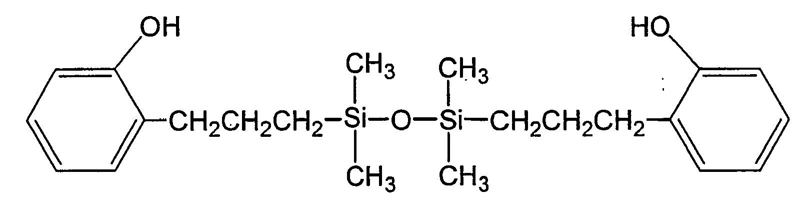

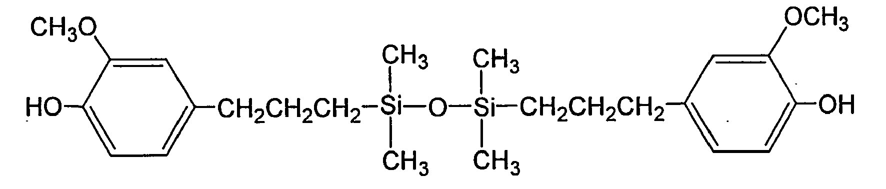

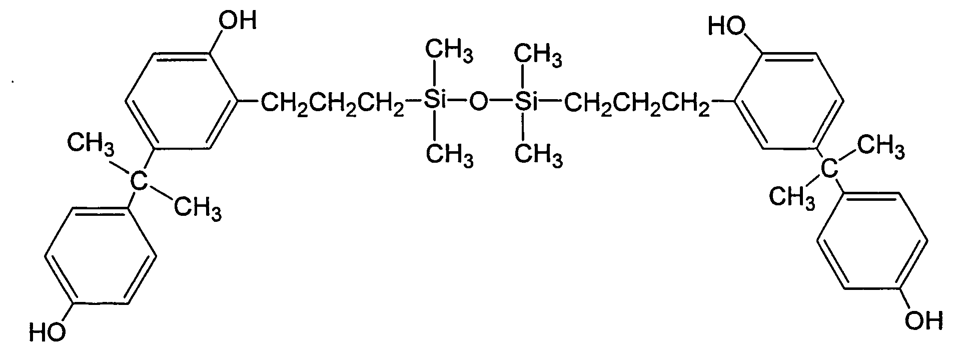

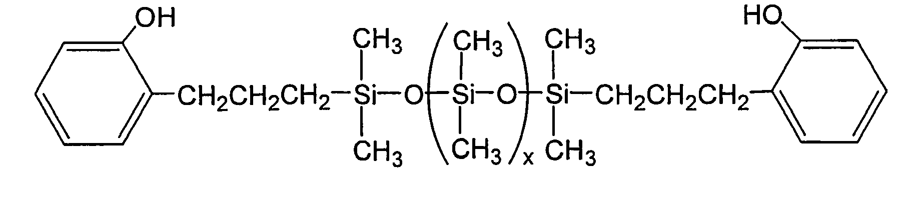

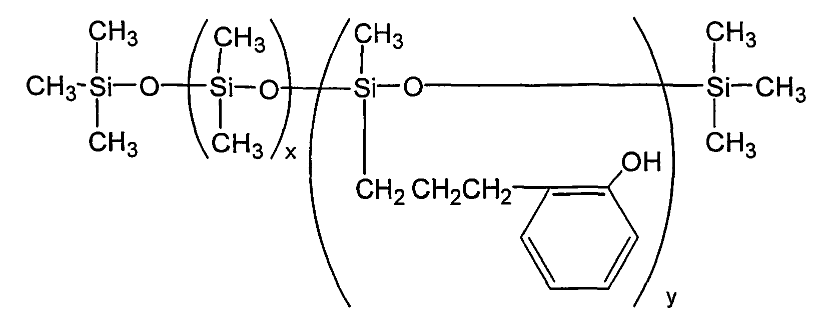

There are no special restrictions with regard to the method that can be used for the preparation of he organosiloxane of component (B). For example, it can be obtained by causing a hydrosilylation reaction between an alkenyl-containing phenolic compound and silicon-bonded hydrogen atoms.

There are no special restrictions with regard to the state of component (B) at 25°C, and it can be solid or liquid, but the liquid state will be more convenient for handling. When at 25°C component (B) is liquid, it should have viscosity within the range of 1 to 1,000,000 mPa·s, preferably within the range of 10 to 5,000 mPa·s. If viscosity at 25°C is below the lower recommended limit, this will impair mechanical strength of a solid body obtained by curing the aforementioned composition. If, on the other hand, the viscosity exceeds the upper recommended limit, the composition will be difficult to handle.

There are no special restrictions with regard to the content of component (B) in the composition of the invention. However, it can be recommended to use this component in an amount of 0.1 to 500 parts by weight, preferably 0.1 to 200 parts by weight per 100 parts by weigh of component (A). When component (B) contains phenolic hydroxyl groups, it is recommended that the mole ratio of the phenolic hydroxyl groups of component (B) to all epoxy groups of the composition be within the range of 0.2 to 5, preferably 0.3 to 2.5, and even more preferably, 0.8 to 1.5. If the mole ratio of the phenolic hydroxyl groups of component (B) to all epoxy groups of the composition is below the lower recommended limit, it would be difficult to provide complete curing of the composition. If, on the other hand, the mole ratio exceeds the upper recommended limit, this will impair mechanical properties of the cured product.

If necessary, the composition of the invention may incorporate a curing accelerator (C) as an arbitrary component. Such curing accelerator (C) can be represented by a tertiary amine compound; an organic metal compound of such a metal as aluminum, zirconia, etc.; a phosphine, or a similar organic phosphorous compound; as well as a heterocyclic amine compound, complex boron compound, organic ammonium salt, organic sulfonium salt, organic peroxide, or reaction products of the above compounds. For example, this can be triphenylphosphine, tributylphosphine, tri(p-methylphenyl) phosphines, tri(nonylphenyl) phosphines, triphenylphosphine-triphenylborate, tetraphenylphosphine-tetraphenylborate, or another phosphorous compound; tiethylamine, benzyldimethylamine, α-methylbenzyldimethylamine, 1,8-diazabicyclo [5.4.0] undecene-7, or other tertiary amines; 2-methylimidazole, 2-phenylimidazole, 2-phenyl-4-methylimidazole, or a similar imidazole compound. In order to extend the service life of the compound, it can be combined with an encapsulated curing accelerator. An encapsulated curing accelerator can be commercially obtained as an encapsulated amine catalyst that incorporates an amine catalyst in a bisphenol A type epoxy resin (HX-3088, the product of Asahi Chemical Co., Ltd.). There are no special restrictions with regard to the content of component (C) but in general it should be added in an amount of less than 50 parts by weight, preferably 0.01 to 50 parts by weight, and even more preferably, 0.1 to 5 parts by weight per 100 parts by weight of component (A).

In order to improve mechanical strength of the composition, it may incorporate a filler (D). Such filler (D) may be comprised of glass fibers, alumina fibers, ceramic fibers composed of alumina and silica, boron fibers, zirconia fibers, silicon carbide fibers, metal fibers, or similar fibrous fillers; fused silica, crystalline silica, precipitated silica, fumed silica, baked silica, zinc oxide, baked clay, carbon black, glass beads, alumina, talc, calcium carbonate, clay, aluminum hydroxide, magnesium hydroxide, barium sulfate, aluminum nitride, boron nitride, magnesia, titania, beryllium oxide, kaolin, mica, zirconia, or other inorganic fillers; fine powders of gold, silver, copper, aluminum, nickel, palladium, alloys or brasses of the above metals, shape memory alloys, solders, or other fine metal powders; powders of ceramic, glass, quartz, organic resins, or similar materials electroplated or surface-coated by vapor deposition with gold, nickel, copper, etc. The above fillers may be used in a mixture of two or more. Most preferable are alumina, crystalline silica, aluminum nitrate, boron nitrate, or similar electrically conductive powders, as well as fused silica, precipitated silica, fumed silica, or a similar reinforcement powder. Silver powder is preferable when a cured body of the composition should possess electrical and thermal conductivity. Thermal conductivity of a cured body of the composition can also be improved by compounding the composition with an alumina powder. The powder particles may have the shape of grounded particles, or may be spherical, fibrous, rod-like, flake-like, scale-like, plate-like, coil-like, etc. There are no special restrictions with regard to the size of the particles, but in general their maximum dimension should not exceed 200 µm, and on average should be within the range of 0.001 to 50 µm. Also there are no special restrictions with regard to the content of component (D), but it is recommended to add this component in an amount of no more than 2,000 parts by weight, preferably within the range of 10 to 2,000 parts by weight, and even more preferably, within the range of 50 to 1,000 parts by weight per 100 parts by weight of the sum of components (A) and (B).

In order to reduce viscosity of the composition, improve workability of the composition, and reduce the modulus elasticity of the cured body, the composition may be additionally combined with an organosiloxane (E) that has a functional group reactive to an epoxy group or phenolic hydroxyl group. The organosiloxane of component (E) should be excepted from the components (A) and (B). The aforementioned functional group may be comprised of an epoxy-reactive primary amine group, secondary amine group, hydroxyl group, phenolic hydroxyl group, carboxylic acid group, acid anhydride group, mercapto group, and a silanol group. From the point of view of improved reactivity and longer pot life, the phenolic hydroxyl group is preferable. When component (B) contains a phenolic hydroxyl group, it is preferable to have the aforementioned functional group in the form of an epoxy group. It is recommended that component (E) has a greater functional group equivalent than in component (B) and a smaller molecular weight and lower viscosity than in component (A). Specific examples of component (E) are the following: polydimethylsiloxane with glycidoxypropyl groups on the molecular chain terminals; polydimethylsiloxane with hydroxyphenyl groups on the molecular chain terminals; and polydimethylsiloxane with glycidoxypropyl groups on the molecular chain terminals. There are no special restrictions with regard to the content of component (E), but it can be recommended add this component in an amount of less than 500 parts by weight, preferably 0.1 to 500 parts by weight per 100 parts by weight of component (A).

In order to reduce viscosity of the composition and to improve its workability, the composition can be further combined with a solvent (F). There are no special restrictions with regard to the types of the solvent (F), provided that it is able to dissolve components (A) and (B). It is recommended, however, to use a solvent of a low molecular weight that possesses volatility. Such a solvent (F) can be exemplified by hexane, heptane, or a similar aliphatic hydrocarbon; toluene, xylene, or a similar aromatic hydrocarbon; acetone, methylethylketone, methylisobutylketone, or a similar ketone. Also there are no special restrictions with regard to the amounts in which component (F) can be used. For better workability of the composition it can be recommended to use component (F) in an amount of less than 100 parts by weight per 100 parts by weight of the sum of components (A) and (B).

In order to improve curability, workability, and adhesive properties of the composition and to adjust modulus of elasticity in a cured body of the composition, the latter can be further combined with an organic epoxy compound (G). There are no restrictions with regard to the state of component (G) at 25°C, and it may be solid or liquid, but the liquid state is preferable. Component (G) can be exemplified by a bisphenol A type epoxy resin, bisphenol F type epoxy resin, or alicyclic epoxy resin. There are no restrictions with regard to the amounts in which component (G) can be used, but it can be recommended to use it in an amount not exceeding 500 parts by weight, preferably within the range of 0.1 to 500 parts by weigh per 100 parts by weight of component (A).

In order to improve adhesion of the composition to a substrate during curing, a mixture of components (A) and (B), or a the aforementioned mixture with component (D) dispersed in it can be additionally combined with a coupling agent, such as a silane coupling agent, titanate coupling agent, or the like. The following are specific examples of such coupling agents: 3-glycidoxypropyl-trimethoxysilane, 3-glycidoxypropylmethyldimethoxysilane, 2-(3,4-epoxycyclohexyl) ethyl-trimethoxysilane, or a similar epoxy-containing alkoxysilane; N-(2-aminoethyl)-3-aminopropyl-trimethoxysilane, 3-aminopropyl-triethoxysilane, N-phenyl-3-aminopropyl-trimethoxysilane, or a similar amino-containing alkoxysilane; 3-mercaptopropyl-trimethoxysilane or a similar mercapto-containing alkoxysilane. The titanate coupling agent can be represented by i-propoxytitanium tri(i-isostearate). There are no special restrictions with regard to amounts in which these coupling agents can be used, but it can be recommended to use them in an amount of less than 10 parts by weight, preferably 0.01 to 10 parts by weight per 100 parts by weight of component (A).

The composition can be combined with other arbitrary components such as tetramethoxysilane, tetraethoxysilane, dimethyldimethoxysilane, methylphenyldimethoxysilane, methylphenyldiethoxysilane, phenyltrimethoxysilane, methyltrimethoxysilane, methyltriethoxysilane, vinyltrimethoxysilane, allyltrimethoxysilane, allyltriethoxysilane, or a similar alkoxysilane.

The composition of the invention is prepared by mixing components (A) and (B), if necessary, with other components. There are no restrictions with regard to a method that can be used for mixing the components. For example, components (A), (B), and other arbitrary components can be mixed simultaneously, or arbitrary components can be added after premixing components (A) and (B). There are no restrictions also with regard to the mixing equipment. This can be a single-axle or biaxial continuous-action mixer, two-roller mill, Ross mixer, Hobart mixer, dental mixer, planetary mixer, or a kneader-mixer.

The composition of the invention is suitable for use in conjunctions with transfer molds, injection molds, potting, casting, powdered application, application by immersion, or dropwise addition. Various methods can also be selected from potting or dispensing, screen printing, or application by spreading, etc. A liquid or paste-like state of the composition are advantageous for optimal matching to specific conditions and for decrease in the amount of the used material. Since a cured body obtained after curing the composition possesses excellent flexibility and adhesive properties, the composition is suitable for use as a sealant, casting agent, coating agent, adhesive agent, etc. in conjunction with parts of electrical and electronic devices. In particular, the curable silicone composition that possesses thermally conductive properties can be use as a thermal interface material (TIM).

The following is a detailed description of an electronic device made in accordance with the invention.

Electronic devices of the present invention are characterized by being sealed or adhesively attached with the use of a cured body of the curable silicone composition of the invention. Such devices can be exemplified by diodes, transistors, thyristors, monolithic IC's, hybrid IC's, LSI, and VLSI. The invention also covers semiconductor elements, e.g., those semiconductor elements that are used in diodes, transistors, thyristors, monolithic IC's, or hybrid IC's.

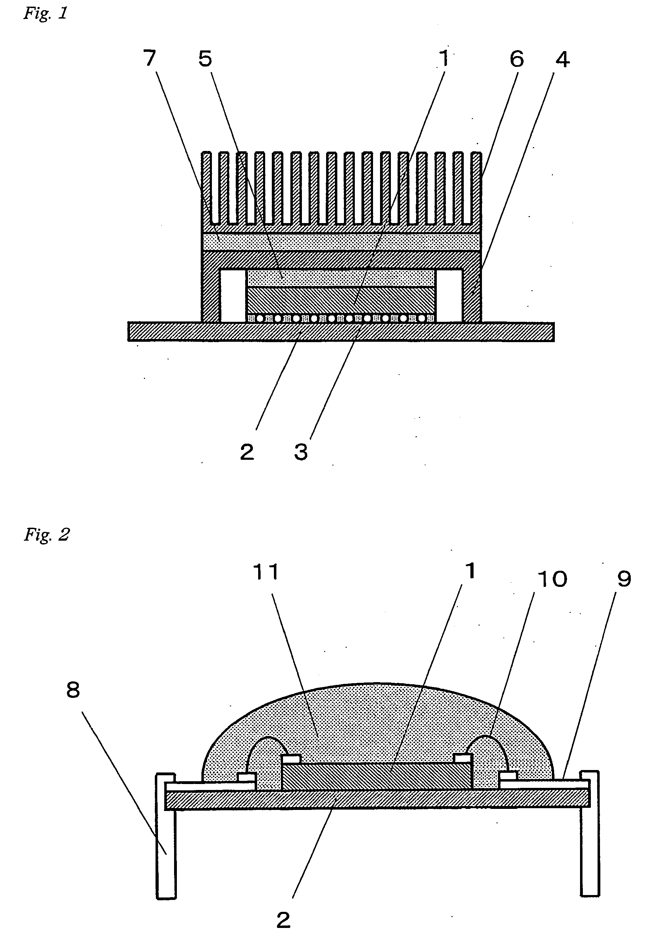

Fig. 1 is a cross-sectional view of an LSI shown as an example of an electronic device o the invention. The electronic device of the invention shown in Fig. 1 utilizes heat radiation members in the form of thermally conductive cured body obtained from the curable silicone composition of the invention that contains a thermally conductive powder. More specifically, the deice of the invention utilizes the aforementioned member as thermal interface material (TIM). The aforementioned curable silicone compositions that possess thermal conductivity was prepared by the methods described below in Application Examples 5, 6, and 8 to 11. The electronic device shown in Fig. 1 consists of a semiconductor element 1 that is electrically connected to a substrate 2 with circuit elements via a solder bumps such as ,e.g., a ball grid 3, provided on the aforementioned semiconductor element 1. The material of the substrate 2 may be comprised of a glass-fiber reinforced epoxy resin, bakelite resin, phenol resin, or a similar organic resin; alumina, or another ceramics; copper, aluminum, or another metal. In addition to the semiconductor element 1, the substrate 2 may support resistors, capacitors, coils, or other electronic parts. In the device of Fig. 1. the space between the semiconductor element 1 and the substrate 2 is filled with an underfill material that can be arbitrary.

The semiconductor element 1 and a heat spreader 4 are in contact via a heat-radiating element 5. The heat spreader 4 and a heat radiating fin 6 are in contact via a heat-radiating element 7. The hear spreader 4 and heat radiating fin 6 are made from aluminum, copper, nickel, or a similar metal. The electronic device shown in Fig. 1 is characterized by the fact that heat radiating elements 5 and/or 7 are made from a cured body of the curable silicone composition of the invention. The cured body of the composition of the invention can be used for adhesively interconnecting either the semiconductor element 1 and the heat spreader 4, or the heat spreader 4 and the heat radiation fin 6. For maintenance purposes, in the device of the invention the heat radiating member 7 can be replaced by thermally conductive grease.

Fig. 2 is a cross-sectional view of an electronic LSI device made in accordance with the invention. The electronic device of Fig. 2 utilizes a cured body of the curable silicone composition of the invention as a sealing member. Such a cured body should demonstrate high mechanical strength rather than heat-conductive properties, and the composition of the invention for these purposes can be prepared as described in subsequent Application Examples 1 to 4, 7, and 12. The electronic device of Fig. 2 is comprised of a semiconductor element 1 installed on a substrate 2, where the semiconductor element 1 and internal leads 9 that are connected to the external leads 8 are electrically interconnected through bonding wires 10. In addition to the semiconductor element 1, the substrate 2 may support resistors, capacitors, coils, or other electronic elements. The bonding wires 10 can be made from gold, copper, or aluminum. The semiconductor element 1, bonding wires 10, can be made from gold, copper, or semiconductor element, bonding wires 10, and a part of internal leads 9 are sealed with sealant 11.

There are no special restrictions with regard to a method for manufacturing a semiconductor device. For example, the following method can be used for manufacturing a semiconductor device shown in Fig. 1. A semiconductor element 1 is placed onto a substrate 2, and then the semiconductor element 1 and the substrate 2 are electrically connected by means of a ball grid 3. If necessary, an underfill material is introduced. Following this, a curable silicone composition that possesses heat-conducting properties is applied onto the surface of the semiconductor element, a heat spreader 4 is attached, and the curable silicone composition coating is cured. A thermally conductive grease or a curable silicone composition that possesses thermally conductive properties is applied onto the heat spreader 4, and a heat radiating fin 6 are attached. If a curable silicone composition is used, the latter is subject to curing.

Another method for manufacturing a semiconductor device is illustrated with reference to Fig. 2. A semiconductor element 1 is attached to a substrate 2 by using a die bond agent, or the like, and then pads on the semiconductor element 1 and pads on the internal leads 9 are wire-bonded by means of bonding wires 10. Following this, a curable silicone composition is applied onto the semiconductor element 1, the semiconductor element 1, bonding wires 10, and portions of internal leads 9 are filled with the curable silicone composition, and the curable silicone composition is cured.

### Examples

The curable silicone composition of the invention and electronic devices of the invention will be further described in detail with reference to application and comparative examples. Characteristics of the curable silicone composition and cured products were measured by the methods described below. In the subsequent application examples, weight-average molecular weights were measured by gel permeation chromatography using toluene as a medium, and the measured values of the weight-average molecular weights were recalculated with reference to polystyrene.

### [Viscosity]

Viscosity of the curable resin composition at 25°C was measured with the use of an E-type viscometer (the product of Tokimec, Inc., digital viscometer, Model DV-U-E Type II), under the following condition: speed of rotation 2.5 rpm.

### [Composite Modulus of Elasticity]

After the curable resin composition was defoamed at 70 mmHg, it was loaded into a mold having a 10 mm-wide, 50 mm-long, and 2 mm-deep cavity, and after pressure curing for 60 min. under conditions of 150°C and 2.5 MPa was completed, the obtained cured specimen was subjected to secondary heat treatment in an oven for 2 hours at 180°C. The composite modulus of elasticity of the obtained specimen at 25°C was measured with the use of the ARES viscoelasticity tester (the product of Rheometric Scientific Co. , Model RDA 700). Measurement was carried out under the following conditions: twist 0.5%; frequency 1 Hz.

### [Adhesive Properties]

The curable resin composition was applied in an amount of about 1 cm³ onto adherends {a glass plate (a float glass plate, the product of Paltec Co., Ltd.); an aluminum plate (A1050P, the product of Paltec Co., Ltd.); a nickel plate (SPCC-SB, the product of Paltec Co., Ltd.); a copper plate (C1100P, the product of Paltec Co., Ltd.), gold-plated plate (C2801P, the product of Nippon Test Panel Co., Ltd.)}. The units were heated in an oven for 2 hours at 125°C and then in an oven for another 2 hours at 180°C. As a result, specimens for evaluating adhesive properties were produced. The cured coatings were separated from the specimens by mean of a dental spatula, and the separation conditions were designated as follows:
CF: separation with fracture of the coating material,
TCF: separation with a thin residual layer left on the interface,
AF: complete separation through interface.

### [Buckling]

A mold (10 mm wide x 50 mm long x 1 mm deep) was placed onto a polyimide film (the product of Ube Industries Co., Ltd., Upilex 125S, thickness = 125 µm), the mold was filled with a thermosetting silicone composition, and then a Teflon® sheet was applied, and the unit was subjected to pressure-molding during 10 min. at 110°C. Following this, a cured body in a semicured state attached to the polyimide film was removed from the mold and subjected to post-curing for 2 hours in an oven with circulation of hot air at 180°C. The unit was cooled to room temperature, and buckling of the polyamide film was measured by the following method. The polyimide film was placed onto a flat table, one short side of the rectangular plate was fixed to the table, and the distance from the table to two end points of the opposite side was measured by a caliper. An average value of two measurements was used as a criterion for evaluation of buckling.

### [Thermal Resistance]

The curable silicone composition was sandwiched between two silicone chips (10 mm x 10 mm x 0.75 mm) to the thickness of 50 µm, and the sandwich was cured at 130°C by heating for 1 hour in a hot-air-circulation oven. Following this, post-curing was carried out in the hot-air-circulation oven for 3 hours at 150°C, whereby a specimen for measuring thermal resistance was produced. Thermal resistance of a product obtained by curing the composition was obtained by measuring thermal resistance of the aforementioned specimen with the use of a thermal resistance tester from Hitachi, Ltd.

### [Application Example 1]

A curable silicone composition was prepared by mixing the following components: 31 parts by weight of a dimethylpolysiloxane (weight-average molecular weight = 47,900; viscosity = 7,400 mPa·s; epoxy equivalent = 580) of the following formula:

X-CH₂CH₂-[(CH₃)₂SiO]₈₄(CH₃)₂Si-CH₂CH₂-X

{wherein X represents a siloxane residual radical of the following unit formula:

[Y(CH₃)₂SiO_{1/2}]₉[-(CH₃)₂SiO_{1/2}]₁[SiO_{4/2}]₆

(wherein Y represents 3-glycidoxypropyl and 3-trimethoxypropyl groups in a ratio of 6:4)}; 2.0 parts by weight of an organopolysiloxane (viscosity = 600 mPa·s) of the following average unit formula:

[G(CH₃)₂SiO_{1/2}]₁₀[SiO_{4/2}]₆

(wherein G is a 3-glycidoxypropyl group); 5 parts by weight of methylhexahydrophthalic anhydride (HN-5500; the product of Hitachi Chemical Industries Co., Ltd.); 1.0 part by weight of an encapsulated amine catalyst (HX-3088, the product of Asahi Kasei Co., Ltd.; amine catalyst content of 40 wt.%); 60.0 parts by weight of fine spherical amorphous silica powder (the product of Admatechs Co., Ltd.; "Admafine"; average particle size = 1.5 µm); and 1 part by weight of 3-glycidoxypropyl-trimethoxysilane. Viscosity of the composition and composite modulus of elasticity, adhesive properties, and buckling characteristics of a cured body were measured. The results of measurements are shown in Table 1.

### [Application Example 2]

A curable silicone composition was prepared by mixing the following components: 30.5 parts by weight of a dimethylpolysiloxane (weight-average molecular weight = 47,900; viscosity = 7,400 mPa·s; epoxy equivalent = 580) of the following formula:

X-CH₂CH₂-[(CH₃)₂SiO]₈₄(CH₃)₂Si-CH₂CH₂-X

{wherein X represents a siloxane residual radical of the following unit formula:

[Y(CH₃)₂SiO_{1/2}]₉[-(CH₃)₂SiO_{1/2}]₁[SiO_{4/2}]₆

(wherein Y represents 3-glycidoxypropyl and 3-trimethoxypropyl groups in a ratio of 6:4)}; 1.5 parts by weight of an organopolysiloxane (viscosity = 600 mPa·s) of the following average unit formula:

[G(CH₃)₂SiO_{1/2}]₁₀[SiO_{4/2}]₆

(wherein G is a 3-glycidoxypropyl group); 7 parts by weight of a liquid phenol-novolac resin (the product of Meiwa Plastic Ind., Ltd.; "MEH8000; hydroxyl group equivalent = 141); 1.0 part by weight of an encapsulated amine catalyst (HX-3088, the product of Asahi Kasei Co., Ltd.; amine catalyst content of 40 wt.%); 60.0 parts by weight of fine spherical amorphous silica powder (the product of Admatechs Co., Ltd.; "Admafine"; average particle size = 1.5 µm); and 1 part by weight of 3-glycidoxypropyltrimethoxysilane. Viscosity of the composition and composite modulus of elasticity, adhesive properties, and buckling characteristics of a cured body were measured. The results of measurements are shown in Table 1.

### [Application Example 3]

A curable silicone composition was prepared by mixing the following components: 31.0 parts by weight of a dimethylpolysiloxane (weight-average molecular weight = 36,000; viscosity = 4,720 mPa·s; epoxy equivalent = 360) of the following formula:

X-CH₂CH₂-[(CH₃)₂SiO]₃₃(CH₃)₂Si-CH₂CH₂-X

{wherein X represents a siloxane residual radical of the following unit formula:

[G(CH₃)₂SiO_{1/2}]₉[-(CH₃)₂SiO_{1/2}]₁[SiO_{4/2}]₆

(wherein G is a 3-glycidoxypropyl group)}; 14.0 parts by weight of an organotrisiloxane (viscosity = 3,800 mPa·s; hydroxyl group equivalent = 317) of the following formula: 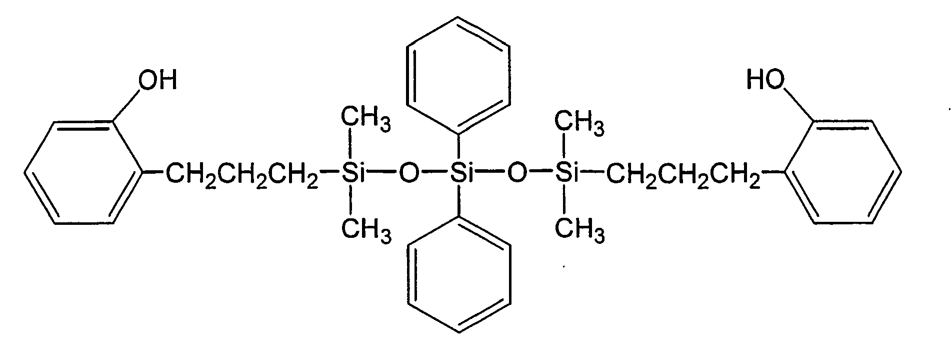 10.0 parts by weight of a mixture of a 40 wt.% encapsulated amine catalyst with a bisphenol A epoxy resin (HX-3721, the product of Asahi Kasei Co., Ltd.); 60.0 parts by weight of fine spherical amorphous silica powder (the product of Admatechs Co., Ltd.; "Admafme"; average particle size = 1.5 µm); and 1 part by weight of 3-glycidoxypropyl-trimethoxysilane. Viscosity of the composition and composite modulus of elasticity, adhesive properties, and buckling characteristics of a cured body were measured. The results of measurements are shown in Table 1.

### [Application Example 4]

A curable silicone composition was prepared by mixing the following components: 13.0 parts by weight of a dimethylpolysiloxane (weight-average molecular weight = 78,000; viscosity = 22,000 mPa·s; epoxy equivalent = 450) of the following formula:

X-CH₂CH₂-[(CH₃)₂SiO]₈₅(CH₃)₂Si-CH₂CH₂-X

{wherein X represents a siloxane residual radical of the following unit formula:

[G(CH₃)₂SiO_{1/2}]₉[-(CH₃)₂SiO_{1/2}]₁[SiO_{4/2}]₆

(wherein G is a 3-glycidoxypropyl group)}; 16.0 parts by weight of a polydimethylsiloxane (viscosity = 77 mPa·s; hydroxyl group equivalent = 700) of the following formula: 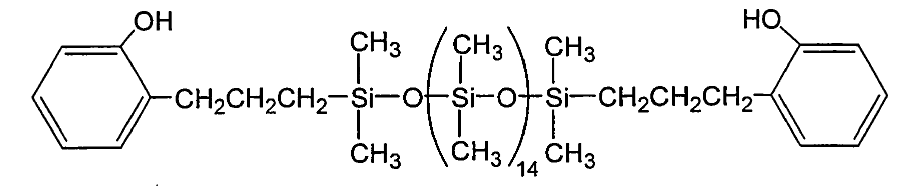 10.0 parts by weight of a mixture of a 40 wt.% encapsulated amine catalyst with a bisphenol A epoxy resin (HX-3721, the product of Asahi Kasei Co., Ltd.); 60.0 parts by weight of fine spherical amorphous silica powder (the product of Admatechs Co., Ltd.; "Admafine"; average particle size = 1.5 µm); and 1 part by weight of 3-glycidoxypropyl-trimethoxysilane. Viscosity of the composition and composite modulus of elasticity, adhesive properties, and buckling characteristics of a cured body were measured. The results of measurements are shown in Table 1.

### [Application Example 5]

A curable silicone composition with thermally conductive properties was prepared by mixing the following components: 9.0 parts by weight of a dimethylpolysiloxane (weight-average molecular weight = 47,900; viscosity = 7,400 mPa·s; epoxy equivalent = 580) of the following formula:

X-CH₂CH₂-[(CH₃)₂SiO]₈₄(CH₃)₂Si-CH₂CH₂-X

{wherein X represents a siloxane residual radical of the following unit formula:

[Y(CH₃)₂SiO_{1/2}]₉[-(CH₃)₂SiO_{1/2}]₁[SiO_{4/2}]₆

(wherein Y represents 3-glycidoxypropyl and 3-trimethoxypropyl groups in a ratio of 6:4)}; 4.0 parts by weight of an organotrisiloxane (viscosity = 2,600 mpa·s; hydroxyl group equivalent = 330) of the following formula: 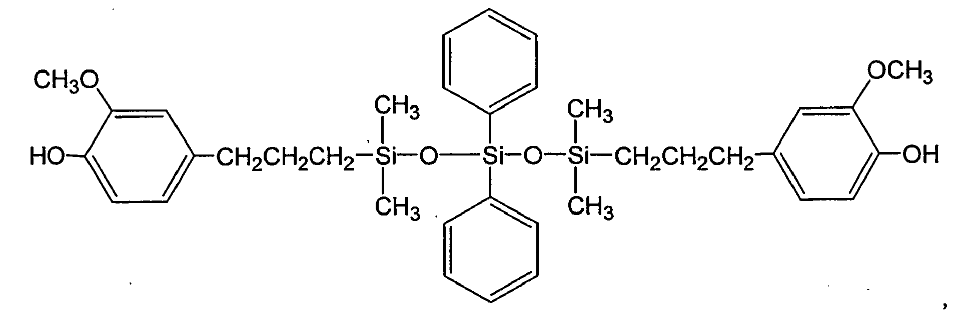 1.0 part by weight of an encapsulated amine catalyst (HX-3088, the product of Asahi Kasei Co., Ltd.; amine catalyst content = 40 wt.%); and 86.0 parts by weight of a flake-shaped silver powder (the product of Fukuda Metal Foil & Powder Co., Ltd.; 50% average grain diameter = 9µm or less; tap density = 4.2 to 5.4 g/cm³; apparent density = 2.7 to 3.4 g/cm³). Viscosity of the composition and composite modulus of elasticity, adhesive properties, and thermal resistance of a cured body were measured. The results of measurements are shown in Table 1.

### [Application Example 6]

A curable silicone composition with thermally conductive properties was prepared by mixing the following components: 6.0 parts by weight of a dimethylpolysiloxane (weight-average molecular weight = 47,900; viscosity = 7,400 mPa·s; epoxy equivalent = 580) of the following formula:

X-CH₂CH₂-[(CH₃)₂SiO]₈₄(CH₃)₂Si-CH₂CH₂-X

{wherein X represents a siloxane residual radical of the following unit formula:

[Y(CH₃)₂SiO_{1/2}]₉[-(CH₃)₂SiO_{1/2}]₁[SiO_{4/2}]₆

(wherein Y represents 3-glycidoxypropyl and 3-trimethoxypropyl groups in a ratio of 6:4)}; 3.0 parts by weight of an organotrisiloxane (viscosity = 2,600 mPa·s; hydroxyl group equivalent = 330) of the following formula: 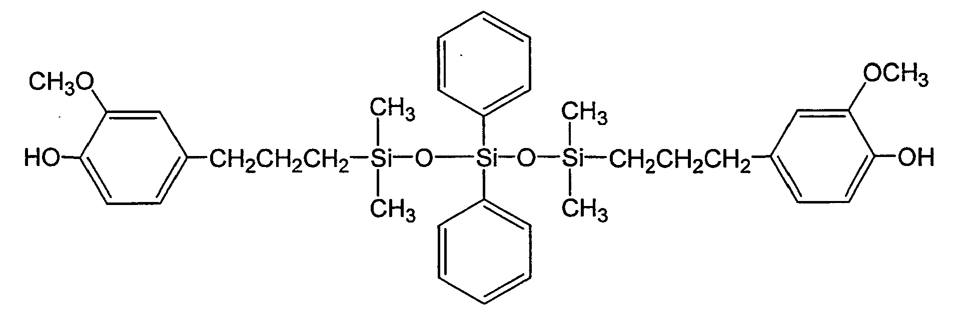 1.0 part by weight of a mixture of a 35wt.% of an encapsulated amine catalyst with bisphenol A epoxy resin and bisphenol F epoxy resin (HX-3941HP, the product of Asahi Kasei Co., Ltd.); and 90.0 parts by weight of a flake-shaped silver powder (the product of Fukuda Metal Foil & Powder Co., Ltd.; 50% average grain diameter = 9 µm or less; tap density = 4.2 to 5.4 g/cm³; apparent density = 2.7 to 3.4 g/cm³). Viscosity of the composition and composite modulus of elasticity, adhesive properties, and thermal resistance of a cured body were measured. The results of measurements are shown in Table 1.

### [Application Example 7]

A curable silicone composition was prepared by mixing the following components: 20.0 parts by weight of a dimethylpolysiloxane (weight-average molecular weight = 78,000; viscosity = 22,000 mPa·s; epoxy equivalent = 450) of the following formula:

X-CH₂CH₂-[(CH₃)₂SiO]₈₅(CH₃)₂Si-CH₂CH₂-X

{wherein X represents a siloxane residual radical of the following unit formula:

[G(CH₃)₂SiO_{1/2}]₉[-(CH₃)₂SiO_{1/2}]₁[SiO_{4/2}]₆

(wherein G is a 3-glycidoxypropyl group)}; 8.0 parts by weight of a bisphenol A type liquid epoxy resin (Epikote 828, the product of Japan Epoxy Resin Co., Ltd.; epoxy equivalent = 190); 23.0 parts by weight of an organopolysiloxane (viscosity = 2,600 mPa·s; hydroxyl group equivalent = 330) of the following formula: 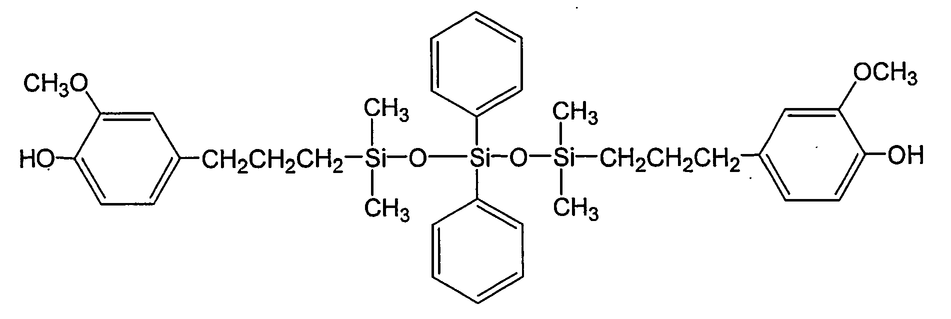 5.0 parts by weight of a mixture of a 35 wt.% encapsulated amine catalyst with a bisphenol A epoxy resin and a bisphenol epoxy resin F (HXA-4921HP, the product of Asahi Kasei Co., Ltd.); 4.0 parts by weight of a fine dry-process silica powder (average primary-grain diameter = 7 to 16 nm); and 40 parts by weight of spherical amorphous silica powder (average particle size = 1.5 µm). Viscosity of the composition and composite modulus of elasticity, adhesive properties, and buckling characteristics of a cured body were measured. The results of measurements are shown in Table 1.

### [Application Example 8]

A curable silicone composition with thermally conductive properties was prepared by mixing the following components: 7.0 parts by weight of a dimethylpolysiloxane (weight-average molecular weight =15,100; viscosity =1,900 mPa·s; epoxy equivalent = 310) of the following formula:

X-CH₂CH₂-[(CH₃)₂SiO]₂₃(CH₃)₂Si-CH₂CH₂-X

{wherein X represents a siloxane residual radical of the following unit formula:

[G(CH₃)₂SiO_{1/2}]₉[-(CH₃)₂SiO_{1/2}]₁[SiO_{4/2}]₆

(wherein G is a 3-glycidoxypropyl group)}; 6.0 parts by weight of an organopolysiloxane (viscosity = 2,600 mPa·s; hydroxyl group equivalent = 330) of the following formula: 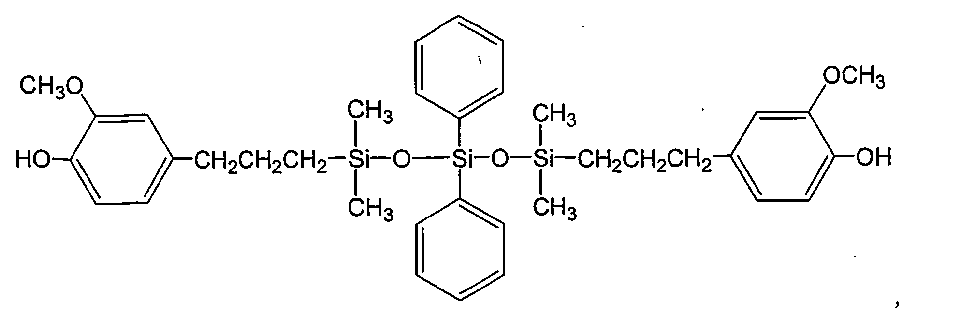 1.0 parts by weight of a mixture of a 35 wt.% encapsulated amine catalyst with a bisphenol A epoxy resin and a bisphenol epoxy resin F (HX-3941HP, the product of Asahi Kasei Co., Ltd.); 85 parts by weight of a 11/3 weight-ratio mixture of a spherical fine alumina powder (average particle size = 8.6 µm) and a spherical fine alumina powder (average particle size = 3 µm); and 1 part by weight of a 3-glycidoxypropyl-trimethoxysilane. Viscosity of the composition and composite modulus of elasticity, adhesive properties, and thermal resistance of a cured body were measured. The results of measurements are shown in Table 1.

### [Application Example 9]

A curable silicone composition with thermally conductive properties was prepared by mixing the following components: 4.2 parts by weight of a dimethylpolysiloxane (weight-average molecular weight = 47,900; viscosity = 7,400 mPa.s; epoxy equivalent = 580) of the following formula:

X-CH₂CH₂-[(CH₃)₂SiO]₈₄(CH₃)₂Si-CH₂CH₂-X

{wherein X represents a siloxane residual radical of the following unit formula:

[Y(CH₃)₂SiO_{1/2}]₉[-(CH₃)₂SiO_{1/2}][SiO_{4/2}]₆

(wherein Y represents 3-glycidoxypropyl and 3-trimethoxypropyl groups in a ratio of 6:4)}; 1.2 parts by weight of an organotrisiloxane (viscosity = 2,600 mPa·s; hydroxyl group equivalent = 330) of the following formula: 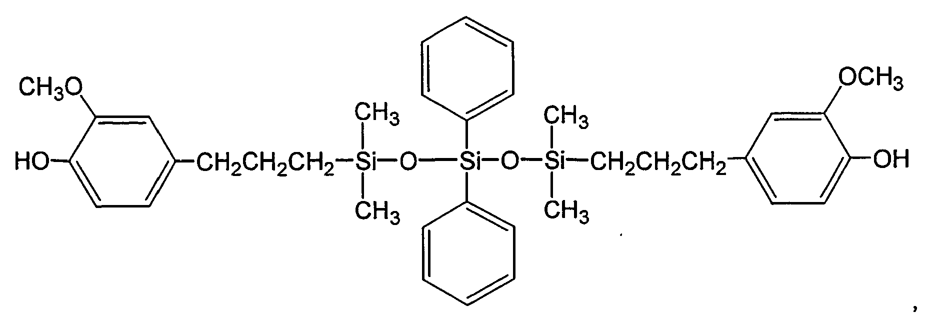 1.0 part by weight of a mixture of a 35wt.% of an encapsulated amine catalyst with bisphenol A epoxy resin and bisphenol F epoxy resin (HX-3941HP, the product of Asahi Kasei Co., Ltd.); 90.0 parts by weight of a flake-shaped silver powder (the product of Fukuda Metal Foil & Powder Co., Ltd.; 50% average grain diameter = 9µm or less; tap density = 4.2 to 5.4 g/cm³; apparent density = 2.7 to 3.4 g/cm³); and 3.6 part by weight of a dimethylpolysiloxane of formula:

[(CH₃)₃SiO[(CH₃)₂SiO]₂₅Si(CH₃)₂]-Y

{wherein Y is a dimethylpolysiloxane (weight-average molecular weight = 2500; viscosity = 75 mPa·s) of the following formula:

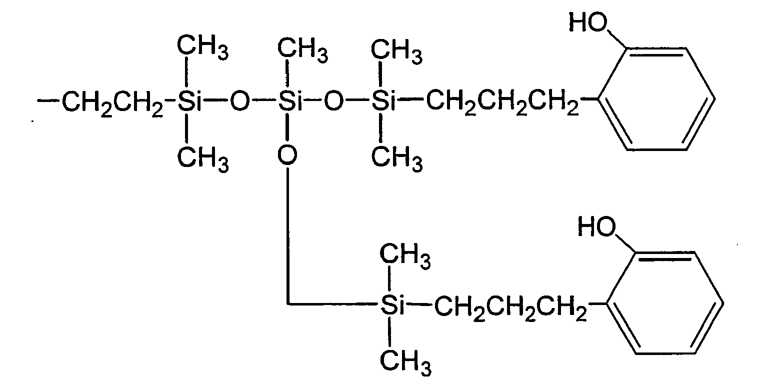

Viscosity of the composition and composite modulus of elasticity, adhesive properties, and thermal resistance of a cured body were measured. The results of measurements are shown in Table 1.

### [Application Example 10]

A curable silicone composition with thermally conductive properties was prepared by mixing the following components: 4.9 parts by weight of a dimethylpolysiloxane (weight-average molecular weight = 47,900; viscosity = 7,400 mPa·s; epoxy equivalent = 580) of the following formula:

X-CH₂CH₂-[(CH₃)₂SiO]₈₄(CH₃)₂Si-CH₂CH₂-X

{wherein X represents a siloxane residual radical of the following unit formula:

[Y(CH₃)₂SiO_{1/2}]₉[-(CH₃)₂SiO_{1/2}]₁[SiO_{4/2}]₆

(wherein Y represents 3-glycidoxypropyl and 3-trimethoxypropyl groups in a ratio of 6:4)}; 1.3 parts by weight of an organotrisiloxane (viscosity = 2,600 mPa·s; hydroxyl group equivalent = 330) of the following formula: 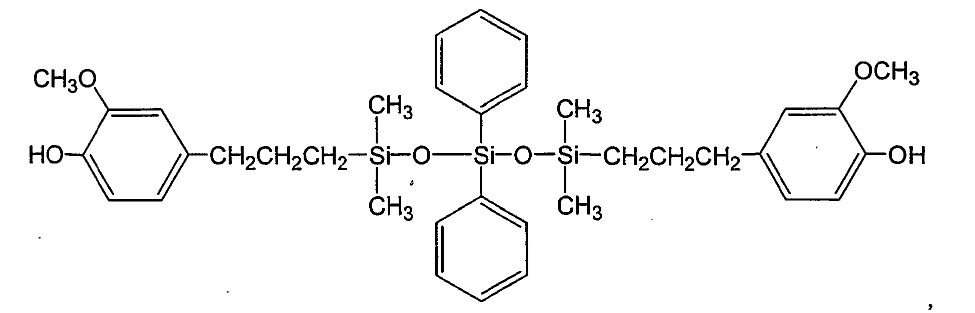 1.0 part by weight of a mixture of a 35wt.% of an encapsulated amine catalyst with bisphenol A epoxy resin and bisphenol F epoxy resin (HX-3941HP, the product of Asahi Kasei Co., Ltd.); and 90.0 parts by weight of a flake-shaped silver powder (the product of Fukuda Metal Foil & Powder Co., Ltd.; 50% average grain diameter = 9 µm or less; tap density = 4.2 to 5.4 g/cm³; apparent density = 2.7 to 3.4 g/cm³); and 4.8 part by weight of an organopolysiloxane (weight-average molecular weight = 2,900; viscosity = 90 mPa·s) of the following formula:

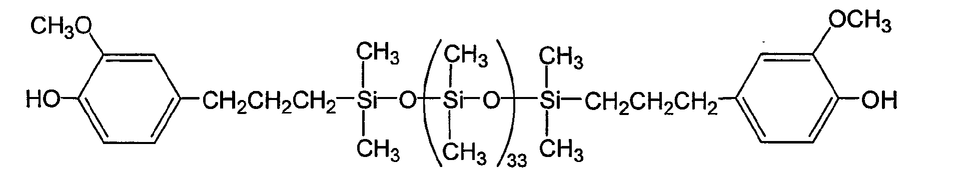

Viscosity of the composition and composite modulus of elasticity, adhesive properties, and thermal resistance of a cured body were measured. The results of measurements are shown in Table 1.

### [Application Example 11]

A curable silicone composition with thermally conductive properties was prepared by mixing the following components: 3.5 parts by weight of a dimethylpolysiloxane (weight-average molecular weight = 47,900; viscosity = 7,400 mPa·s; epoxy equivalent = 580) of the following formula:

X-CH₂CH₂-[(CH₃)₂SiO]₈₄(CH₃)₂Si-CH₂CH₂-X

{wherein X represents a siloxane residual radical of the following unit formula:

[Y(CH₃)₂SiO_{1/2}]₉[-(CH₃)₂SiO_{1/2}]₁[SiO_{4/2}]₆

(wherein Y represents 3-glycidoxypropyl and 3-trimethoxypropyl groups in a ratio of 6:4)}; 1.5 parts by weight of an organotrisiloxane (viscosity = 2,600 mPa·s; hydroxyl group equivalent = 330) of the following formula: 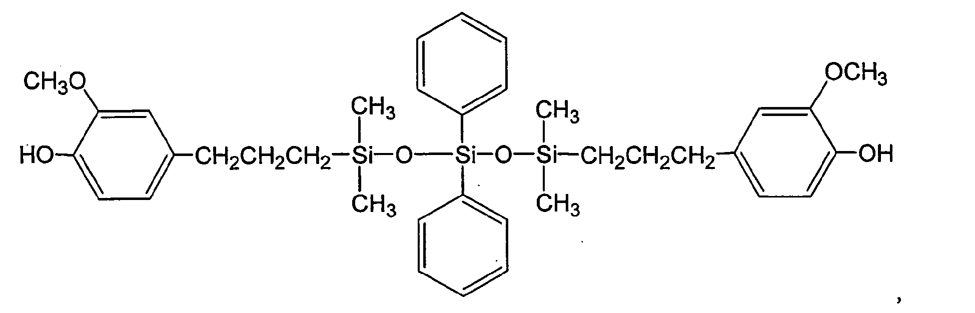 1.0 part by weight of mixture of a 35 wt.% encapsulated amine catalyst with bisphenol A epoxy resin and bisphenol F epoxy resin (HXA-4921HP, the product of Asahi Kasei Co., Ltd.; 94.0 parts by weight of a flake-shaped silver powder (the product of Fukuda Metal Foil & Powder Co., Ltd.; 50% average grain diameter = 9 µm or less; tap density = 4.2 to 5.4 g/cm³; apparent density = 2.7 to 3.4 g/cm³); and 4 parts by weight of paraffin having a 220°C boiling point (the product of Nippon Oil Corporation; Isozole 400K). Viscosity of the composition and composite modulus of elasticity, adhesive properties, and thermal resistance of a cured body were measured. The results of measurements are shown in Table 1.

### [Application Example 12]

A curable silicone composition with thermally conductive properties was prepared by mixing the following components: 6.0 parts by weight of a dimethylpolysiloxane (weight-average molecular weight = 47,900; viscosity = 7,400 mPa·s; epoxy equivalent = 580) of the following formula:

X-CH₂CH₂-[(CH₃)₂SiO]₈₄(CH₃)₂Si-CH₂CH₂-X

{wherein X represents a siloxane residual radical of the following unit formula:

[Y(CH₃)₂SiO_{1/2}]₉[-(CH₃)₂SiO_{1/2}]₁[SiO_{4/2}]₆

(wherein Y represents 3-glycidoxypropyl and 3-trimethoxypropyl groups in a ratio of 6:4)}; 12.0 parts by weight of a polydimethylsiloxane (viscosity = 77 mPa·s; hydroxyl group equivalent = 700) of the following formula: 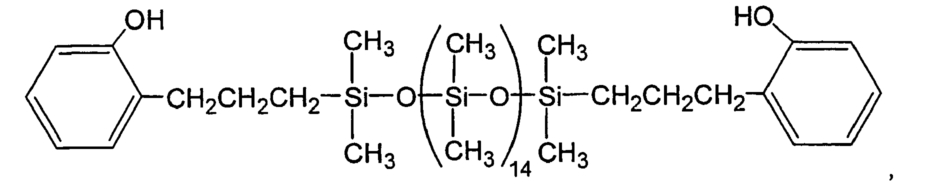 2 parts by weight of an imidazole derivative (the product of Ajinomoto Co., Ltd.; Amicure PN-3); 80.0 parts by weight of fine spherical amorphous silica powder (the product of Admatechs Co., Ltd.; "Admafine"; average particle size = 1.5 µm); and 1 part by weight of 3-glycidoxypropyltrimethoxysilane. Viscosity, composite modulus of elasticity, and adhesive properties of the obtained curable silicone composition were measured. The results of measurements are shown in Table 1.

### [Comparative Example 1]

A curable silicone composition was prepared by mixing the following components: 27.0 parts by weight of a liquid bisphenol A type epoxy resin (the product of Japan Epoxy Resin Co., Ltd.; Epikote 828; epoxy equivalent = 190); 11.0 parts by weight of methylhexahydrophthalic anhydride (HN-5500; the product of Hitachi Chemical Industries Co., Ltd.); 1.0 part by weight of an encapsulated amine catalyst (hex-3088, the product of Asahi Kasei Co., Ltd.; amine catalyst content of 40 wt.%); 60.0 parts by weight of fine spherical amorphous silica powder (the product of Admatechs Co., Ltd.; "Admafine"; average particle size =1.5 µm); and 1 part by weight of 3-glycidoxypropyltrimethoxysilane. Viscosity of the obtained composition, and composite modulus of elasticity, adhesive properties, and buckling characteristics of a cured body were measured. The results of measurements are shown in Table 1.

### [Comparative Example 2]

A curable silicone composition was prepared by mixing the following components: 14 parts by weight of a disiloxane (viscosity = 10 mPa·s; epoxy equivalent = 180) of the following formula:

G-(CH₃)₂SiOSi(CH₃)₂-G

(wherein G is a 3-glycidoxypropyl group); 23.0 parts by weight of an organotrisiloxane (viscosity = 2,600 mPa·s; hydroxyl group equivalent = 330) of the following formula: 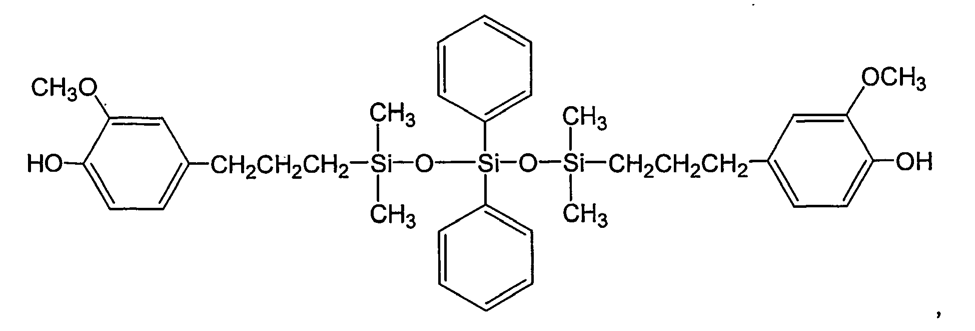 1.0 part by weight of an encapsulated amine catalyst (HX-3088, amine catalyst content = 40 wt.%; the product of Asahi Kasei Co., Ltd.); 60.0 parts by weight of a fine spherical amorphous silica powder (the product of Admatechs Co., Ltd.; "Admafine"; average particle size =1.5 µm); and 1 part by weight of 3-glycidoxypropyl-trimethoxysilane. Viscosity of the composition, and composite modulus of elasticity, adhesive properties of the obtained curable silicone composition, and buckling characteristics of a cured body were measured. The results of measurements are shown in Table 1. Cured bodies obtained from this composition were extremely brittle.

### [Comparative Example 3]

A curable silicone composition was prepared by mixing the following components: 26.0 parts by weight of a dimethylpolysiloxane (viscosity = 22 mPa·s; epoxy equivalent = 650) of the following formula:

G-(CH₃)₂SiO[(CH₃)₂SiO]₁₄Si(CH₃)₂-G

(wherein G is a 3-glycidoxypropyl group); 12.0 parts by weight of an organotrisiloxane (viscosity = 2,600 mPa·s; hydroxyl group equivalent = 330) of the following formula: 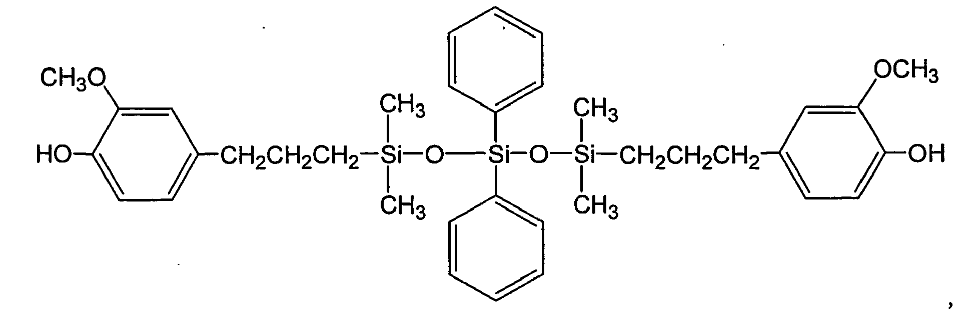 1.0 part by weight of an encapsulated amine catalyst (HX-3088, amine catalyst content = 40 wt.%; the product of Asahi Kasei Co., Ltd.); 60.0 parts by weight of a fine spherical amorphous silica powder (the product of Admatechs Co., Ltd.; "Admafine"; average particle size = 1.5 µm); and 1 part by weight of 3-glycidoxypropyl-trimethoxysilane. Since the obtained composition could not be cured to a sufficient degree even after 12-hour heat treatment at 150°C, composite modulus of elasticity, adhesive properties and buckling characteristics of a cured body were not measured.

### [Comparative Example 4]

A curable silicone composition was prepared by mixing the following components: 85.3 parts by weight of a dimethylpolysiloxane (viscosity = 2,000 mPa·s) capped at both molecular terminals by dimethylvinylsilyl groups; 1.3 parts by weight of a methylhydrogenpolysiloxane (viscosity = 50 mPa·s) capped at both molecular terminals with trimethylsilyl groups; a complex of platinum and 13-divinyl-1,1,3,3-tetramethyldisisloxane used in an amount that ensures 5 ppm concentration of metallic platinum in the composition), and 12.3 parts by weight of affine dry-process silica powder (an average primary-particle size is within the range of 7 to 16 nm). Viscosity of the composition, and composite modulus of elasticity, adhesive properties of the obtained curable silicone composition, and buckling characteristics of a cured body were measured. The results of measurements are shown in Table 1.

### [Comparative Example 5]

A curable silicone composition having thermally conductive properties was prepared by mixing the following components: 5.0 parts by weight of a liquid bisphenol A epoxy resin (the product of Japan Epoxy Resin Co., Ltd.; Epikote 828, epoxy equivalent = 190); 4.0 parts by weight of methylhexahydrophthalic anhydride (HN-5500; the product of Hitachi Chemical Industries Co., Ltd.); 1.0 part by weight of a mixture of a 35wt.% of an encapsulated amine catalyst with bisphenol A epoxy resin and bisphenol F epoxy resin (HX-3941HP, the product of Asahi Kasei Co., Ltd.); and 90.0 parts by weight of a flake-shaped silver powder (the product of Fukuda Metal Foil & Powder Co., Ltd.; 50% average grain diameter = 9 µm or less; tap density = 4.2 to 5.4 g/cm³; apparent density = 2.7 to 3.4 g/cm³). Viscosity of the composition, and composite modulus of elasticity, adhesive properties of the obtained curable silicone composition, and heat resistance characteristics of a cured body were measured. The results of measurements are shown in Table 1.

### [Comparative Example 6]

A curable silicone composition having was prepared by mixing the following components: 17.0 parts by weight of a liquid bisphenol A epoxy resin (the product of Japan Epoxy Resin Co., Ltd.; Epikote 828, epoxy equivalent = 190); 12.0 parts by weight of methylhexahydrophthalic anhydride (HN-5500; the product of Hitachi Chemical Industries Co., Ltd.); 10.0 part by weight of a mixture of a 40 wt.% of an encapsulated amine catalyst with bisphenol A epoxy resin (HX-3721, the product of Asahi Kasei Co., Ltd.); 60.0 parts by weight of a fine spherical amorphous silica powder (the product of Admatechs Co., Ltd.; "Admafine"; average particle size = 1.5 µm); and 1 part by weight of 3-glycidoxypropyltrimethoxysilane. Viscosity of the composition, and composite modulus of elasticity, adhesive properties of the obtained curable silicone composition, and buckling characteristics of a cured body were measured. The results of measurements are shown in Table 1.

**[Table 1]**

| | | Application Examples | | | | | | | | | | | | Comparative Examples | | | | |
|---|---|---|---|---|---|---|---|---|---|---|---|---|---|---|---|---|---|---|
| | | 1 | 2 | 3 | 4 | 5 | 6 | 7 | 8 | 9 | 10 | 11 | 12 | 1 | 2 | 4 | 5 | 6 |
| Viscosity (Pa·s) | | 302 | 851 | 140 | 40 | 320 | 400 | 480 | 620 | 250 | 250 | 150 | 100 | 18 | 78 | 3** | >1000 | 770 |
| Composite modulus of (MPa) elasticity (MPa) | | 257 | 251 | 730 | 50 | 690 | 1170 | 350 | 600 | 200 | 300 | 800 | 65 | 2470 | 62 | 0.4 | 3400 | 2300 |
| Adhesive properties | Glass Plate | CF | CF | CF | CF | CF | CF | CF | CF | CF | CF | CF | CF | CF | CF | CF | CF | CF |
| | Nickel | TCF | CF | CF | CF | CF | CF | CF | CF | CF | CF | CF | CF | CF | CF | CF | CF | CF |
| | Copper | CF | CF | CF | CF | CF | CF | CF | CF | CF | CF | CF | CF | CF | CF | CF | CF | CF |
| | Aluminum | CF | CF | CF | CF | CF | CF | CF | CF | CF | CF | CF | CF | CF | CF | AF | CF | CF |
| | Gold | CF | CF | CF | CF | CF | CF | CF | CF | CF | CF | CF | CF | CF | CF | AF | CF | CF |
| Buckling (mm) | | 12 | 11 | 5 | 9 | - | - | 12 | - | - | - | - | - | 17 | 17* | 7 | - | 14 |
| Thermal resistance (C·cm²/W) | | - | - | - | - | 0.35 | 0.15 | - | 0.36 | 0.13 | 0.15 | 0.07 | - | - | - | - | 0.20 | - |

| | | | | | | | | | | | | | | | | | | |
|---|---|---|---|---|---|---|---|---|---|---|---|---|---|---|---|---|---|---|
| * after the secondary heat treatment for 12 hours in an oven at 180°C ** measured at 20 rpm | | | | | | | | | | | | | | | | | | |

### Industrial applicability

Since the composition of the invention is suitable for use in conjunctions with transfer molds, injection molds, potting, casting, powdered application, application by immersion, or dropwise addition. Various methods can also be selected from potting or dispensing, screen printing, or application by spreading, etc., and since a cured body obtained after curing the composition possesses excellent flexibility and adhesive properties, the composition is suitable for use as a sealant, casting agent, coating agent, adhesive agent, etc. for parts and units of electrical and electronic devices. In particular, the curable silicone composition that possesses thermally conductive properties can be used as a heat-radiating interface material (TIM).

## Claims

1. A curable silicone composition comprising:
(A) a diorganosiloxane represented by the following general formula:
A-R²-(R¹₂SiO)ₙR¹₂Si-R²-A
{wherein R¹ represents the same or different optionally substituted univalent hydrocarbon groups that do not have unsaturated aliphatic bonds; R² represents bivalent organic groups; A designates siloxane residual radicals represented by the following average unit formula:
(XR¹₂SiO_{1/2})ₐ(SiO_{4/2})_{b}
(wherein R¹ designates the previously mentioned groups; X designates a single bond, hydrogen atom, the previously mentioned group that is designated by R¹, an epoxy-containing alkyl group, or an alkoxysilylalkyl group; at least one X in one molecule is a single bond; at least two X's are epoxy-containing alkyl groups; "a" is a positive number, "b" is a positive number; and "a/b" is a positive number within the range of 0.2 to 4), and "n" is an integer which is equal to or greater than 1}; and
(B) a curing agent for an epoxy resin.

2. The curable silicone composition of Claim 1, wherein "n" in component (A) is an integer equal to or greater than 10.

3. The curable silicone composition of Claim 1, wherein component (B) is a phenol compound.

4. The curable silicone composition of Claim 3, wherein the phenolic hydroxyl group equivalent of component (B) is equal to or below 1,000.

5. The curable silicone composition of Claim 1, wherein the content of component (B) is within the range of 0.1 to 500 parts by weight per 100 parts by weight of component (A).

6. The curable silicone composition of Claim 1, further comprising (C) a curing accelerator.

7. The curable silicone composition of Claim 6, wherein component (C) is an encapsulated amine-type curing accelerator.

8. The curable silicone composition of Claim 1, wherein the content of said component (C) is 50 or less parts by weight per 100 parts by weight of component (A).

9. The curable silicone composition of Claim 1, further comprising (D) a filler.

10. The curable silicone composition of Claim 9, wherein said component (D) is a thermally conductive powder.

11. The curable silicone composition of Claim 9, wherein said component (D) is a silver powder.

12. The curable silicone composition of Claim 9, wherein said component (D) is an alumina powder.

13. The curable silicone composition of Claim 9, wherein the content of said component (D) is 2,000 or less parts by weight per 100 parts by weight of the sum of components (A) and (B).

14. The curable silicone composition of Claim 1, further comprising (E) an organosiloxane that has a functional group reactive to an epoxy group or phenolic hydroxyl group, with the exception of those of components (A) and (B).

15. The curable silicone composition of Claim 14, wherein the content of said component (E) is 500 or less parts by weight per 100 parts by weight of component (A).

16. The curable silicone composition of Claim 1, further comprising (F) a solvent.

17. The curable silicone composition of Claim 16, wherein the content of said component (F) is 100 or less parts by weight per 100 parts by weight of the sum of components (A) and (B).

18. The curable silicone composition of Claim 1, further comprising (G) an organic epoxy compound.

19. The curable silicone composition of Claim 18, wherein the content of said component (G) is 500 or less parts by weight per 100 parts by weight of component (A).

20. An electronic device adhered or sealed with the use of a cured body produced from a curable silicone composition as claimed in any of Claims from 1 to 19.

## Patentansprüche

1. Eine härtbare Siliconzusammensetzung, enthaltend:
(A) ein Diorganosiloxan, dargestellt durch die folgende allgemeine Formel:
A-R²-(R¹₂SiO)ₙR¹₂Si-R²-A
{wobei R¹ die gleichen oder unterschiedliche optional substituierte einbindige Kohlenwasserstoffgruppen, die keine ungesättigten aliphatischen Bindungen aufweisen, darstellt; R² zweibindige organische Gruppen darstellt; A verbleibende Siloxanreste bezeichnet, dargestellt durch die folgende durchschnittliche Einheitsformel:
(XR¹₂SiO_{1/2})ₐ(SiO_{4/2})_{b}
(wobei R¹ die zuvor erwähnten Gruppen bezeichnet; X eine Einfachbindung, ein Wasserstoffatom, die zuvor erwähnte Gruppe, die durch R¹ bezeichnet wird, eine epoxyhaltige Alkylgruppe oder eine Alkoxysilylalkylgruppe bezeichnet; wenigstens ein X in einem Molekül eine Einfachbindung darstellt; wenigstens zwei X epoxyhaltige Alkylgruppen sind; "a" eine positive Zahl ist, "b" eine positive Zahl ist; und "a/b" eine positive Zahl innerhalb des Bereiches von 0,2 bis 4 ist) und "n" eine ganze Zahl ist, die gleich oder größer 1 ist}; und
(B) ein Vernetzungsmittel für ein Epoxyharz.

2. Die härtbare Siliconzusammensetzung gemäß Anspruch 1, wobei "n" in Komponente (A) eine ganze Zahl ist, die gleich oder größer 10 ist.

3. Die härtbare Siliconzusammensetzung gemäß Anspruch 1, wobei die Komponente (B) eine Phenolverbindung ist.

4. Die härtbare Siliconzusammensetzung gemäß Anspruch 3, wobei das phenolische Hydroxylgruppenäquivalent der Komponente (B) gleich oder unterhalb von 1.000 ist.

5. Die härtbare Siliconzusammensetzung gemäß Anspruch 1, wobei der Gehalt der Komponente (B) innerhalb des Bereiches von 0,1 bis 500 Gewichtsteilen pro 100 Gewichtsteile der Komponente (A) ist.

6. Die härtbare Siliconzusammensetzung gemäß Anspruch 1, außerdem enthaltend (C) einen Vernetzungsbeschleuniger.

7. Die härtbare Siliconzusammensetzung gemäß Anspruch 6, wobei die Komponente (C) ein verkapselter Vernetzungsbeschleuniger vom Amintyp ist.

8. Die härtbare Siliconzusammensetzung gemäß Anspruch 1, wobei er Gehalt der Komponente (C) 50 oder weniger Gewichtsteile pro 100 Gewichtsteile der Komponente (A) ist.

9. Die härtbare Siliconzusammensetzung gemäß Anspruch 1, außerdem enthaltend (D) einen Füllstoff.

10. Die härtbare Siliconzusammensetzung gemäß Anspruch 9, wobei die Komponente (D) ein thermisch leitfähiges Pulver ist.

11. Die härtbare Siliconzusammensetzung gemäß Anspruch 9, wobei die Komponente (D) ein Silberpulver ist.

12. Die härtbare Siliconzusammensetzung gemäß Anspruch 9, wobei die Komponente (D) ein Aluminiumoxidpulver ist.

13. Die härtbare Siliconzusammensetzung gemäß Anspruch 9, wobei der Gehalt der Komponente (D) 2.000 oder weniger Gewichtsteile pro 100 Gewichtsteile der Summe der Komponenten (A) und (B) ist.

14. Die härtbare Siliconzusammensetzung gemäß Anspruch 1, außerdem enthaltend (E) ein Organosiloxan, das eine funktionelle Gruppe enthält, die mit einer Epoxygruppe oder phenolischen Hydoxygruppe reaktiv ist, mit Ausnahme der Komponenten (A) und (B).

15. Die härtbare Siliconzusammensetzung gemäß Anspruch 14, wobei der Gehalt der Komponente (E) 500 oder weniger Gewichtsteile pro 100 Gewichtsteile der Komponente (A) ist.

16. Die härtbare Siliconzusammensetzung gemäß Anspruch 1, außerdem enthaltend (F) ein Lösungsmittel.

17. Die härtbare Siliconzusammensetzung gemäß Anspruch 16, wobei der Gehalt der Komponente (F) 100 oder weniger Gewichtsteile pro 100 Gewichtsteile der Summe der Komponenten (A) und (B) ist.

18. Die härtbare Siliconzusammensetzung gemäß Anspruch 1, außerdem enthaltend (G) eine organische Epoxyverbindung.

19. Die härtbare Siliconzusammensetzung gemäß Anspruch 18, wobei der Gehalt der Komponente (G) 500 oder weniger Gewichtsteile pro 100 Gewichtsteile der Komponente (A) ist.

20. Eine elektronische Vorrichtung, verklebt oder versiegelt unter Verwendung eines gehärteten Körpers, hergestellt aus einer härtbaren Siliconzusammensetzung wie sie in einem der Ansprüche 1 bis 19 beansprucht ist.

## Revendications

1. Composition de silicone durcissable comprenant :
(A) un diorganosiloxane représenté par la formule générale suivante :
A-R²-(R¹₂SiO)ₙR¹₂Si-R²-A
{dans laquelle R¹ représente des groupes hydrocarbures univalents identiques ou différents éventuellement substitués qui n'ont pas de liaisons aliphatiques insaturées ; R² représente des groupes organiques bivalents ; A désigne des radicaux résiduels de siloxane représentés par la formule unitaire moyenne suivante :
(XR¹₂SiO_{1/2})ₐ(SiO_{4/2})_{b}
(dans laquelle R¹ désigne les groupes précédemment mentionnés ; X désigne un atome d'hydrogène à liaison simple, le groupe précédemment mentionné qui est désigné par R¹, un groupe alkyle contenant de l'époxy ou un groupe alcoxysilylalkyle ; au moins un X dans une molécule est une liaison simple ; au moins deux X sont des groupes alkyle contenant de l'époxy ; « a » est un nombre positif, « b »est un nombre positif ; et « a/b » est un nombre positif dans la plage de 0,2 à 4), et « n » est un entier qui est égal ou supérieur à 1} ; et
(B) un agent de durcissement pour une résine époxy.

2. Composition de silicone durcissable selon la revendication 1, dans laquelle « n » dans le composant (A) est un entier égal ou supérieur à 10.

3. Composition de silicone durcissable selon la revendication 1, dans laquelle le composant (B) est un composé de phénol.

4. Composition de silicone durcissable selon la revendication 3, dans laquelle le groupe hydroxyle phénolique équivalent du composant (B) est égal ou inférieur à 1 000.

5. Composition de silicone durcissable selon la revendication 1, dans laquelle la teneur du composant (B) est dans la plage de 0,1 à 500 parties en poids pour 100 parties en poids du composant (A).

6. Composition de silicone durcissable selon la revendication 1, comprenant en outre un accélérateur de durcissement (C).

7. Composition de silicone durcissable selon la revendication 6, dans laquelle le composant (C) est un accélérateur de durcissement de type amine encapsulée.

8. Composition de silicone durcissable selon la revendication 1, dans laquelle la teneur dudit composant (C) est de 50 parties en poids ou moins pour 100 parties en poids du composant (A).

9. Composition de silicone durcissable selon la revendication 1, comprenant en outre une charge (D).

10. Composition de silicone durcissable selon la revendication 9, dans laquelle ledit composant (D) est une poudre thermoconductrice.

11. Composition de silicone durcissable selon la revendication 9, dans laquelle ledit composant (D) est une poudre d'argent.

12. Composition de silicone durcissable selon la revendication 9, dans laquelle ledit composant (D) est une poudre d'alumine.

13. Composition de silicone durcissable selon la revendication 9, dans laquelle la teneur dudit composant (D) est de 2 000 parties en poids ou moins pour 100 parties en poids de la somme des composants (A) et (B).

14. Composition de silicone durcissable selon la revendication 1, comprenant en outre un organosiloxane (E) qui a un groupe fonctionnel réactif à un groupe époxy ou un groupe hydroxyle phénolique, à l'exception de ceux des composants (A) et (B).

15. Composition de silicone durcissable selon la revendication 14, dans laquelle la teneur dudit composant (E) est de 500 parties en poids ou moins pour 100 parties en poids du composant (A).

16. Composition de silicone durcissable selon la revendication 1, comprenant en outre un solvant (F).

17. Composition de silicone durcissable selon la revendication 16, dans laquelle la teneur dudit composant (F) est de 100 parties en poids ou moins pour 100 parties en poids de la somme des composants (A) et (B).

18. Composition de silicone durcissable selon la revendication 1, comprenant en outre un composé époxy organique (G).

19. Composition de silicone durcissable selon la revendication 18, dans laquelle la teneur dudit composant (G) est de 500 de parties en poids ou moins pour 100 parties en poids du composant (A).

20. Un dispositif électronique collé ou scellé à l'aide d'un corps durci fabriqué à partir d'une composition de silicone durcissable selon l'une quelconque des revendications de 1 à 19.
